# EUROPÄISCHE PATENTSCHRIFT

(11) **EP 1 709 850 B1**
(45) Veröffentlichungstag und Bekanntmachung des Hinweises auf die Patenterteilung: **31.10.2007**
(21) Anmeldenummer: 04802934.2
(22) Anmeldetag: 14.12.2004
(51) Int. Cl.: H05K 5/00, B60R 16/02

(54) **ELEKTRONISCHES GERÄT SOWIE VERFAHREN ZUM BONDEN EINES ELEKTRONISCHEN GERÄTES**
ELECTRONIC DEVICE AND METHOD FOR BONDING AN ELECTRONIC DEVICE
APPAREIL ELECTRONIQUE ET PROCEDE POUR REALISER DES CONNEXIONS SUR UN APPAREIL ELECTRONIQUE

(30) Priorität: 29.01.2004 DE 102004004422
(43) Veröffentlichungstag der Anmeldung: 11.10.2006
(73) Patentinhaber: Conti Temic microelectronic GmbH, 90411 Nürnberg (DE)
(72) Erfinder: HANDL, Herbert, 90459 Nürnberg (DE); WENK, Alexander, 91595 Burgoberbach (DE); WIECZOREK, Matthias, 91223 Neunkirchen am Sand (DE)
(86) Internationale Anmeldenummer: PCT/DE2004/002731
(87) Internationale Veröffentlichungsnummer: WO 2005/074341

(56) Entgegenhaltungen:
- WO-A-20/04001807
- US-A- 5 571 027
- US-A- 5 847 572

## Beschreibung

Die Erfindung betrifft ein elektronisches Gerät nach dem Oberbegriff des Anspruches 1. Ferner betrifft die Erfindung ein Verfahren zum Bonden eines elektronischen Gerätes nach Anspruch 5.

Ein elektronisches Gerät nach dem Oberbegriff des Anspruches 1 ist durch offenkundige Vorbenutzung bekannt Dort stützt sich das Elektronikgehäuse an der Grundplatte über eine Auflagerippe in der Nachbarschaft des Bondkontaktträgers ab. Durch Fertigungstoleranzen, insbesondere durch Unebenheiten der Grundplatte bzw. der Auflagerippe ist es möglich, dass das Elektronikgehäuse zumindest bereichsweise nicht über die Auflagerippe an der Grundplatte anliegt. Dies führt dazu, dass in diesen Bereichen keine Abstützung des Elektronikgehäuses in der Nachbarschaft des Bondkontaktträgers erfolgt, Die Lage des Bondkontaktträgers ist aufgrund dieser mangelnden Abstützung nur unscharf definiert. Durch die fehlende Abstützung des Bondkontaktträgers neigt dieser beim Bonden zum Schwingen. Um die Bondverbindung sicherzustellen muss es möglich sein, einen zweiten sogenannten Sicherheitsbond zu setzen, der seinerseits Platz beansprucht. Daher müssen die Bondkontaktträger relativ baugroß ausgeführt werden, um ein sicheres Bonden zu gewährleisten.

Es ist daher die Aufgabe der vorliegenden Erfindung, ein elektronisches Gerät der eingangsgenannten Art derart weiterzubilden, dass eine größere Sicherheit bei der Herstellung einer Bondverbindung gegeben ist.

Der relevante Stand der Technik schließt Dokument US-A-5 847 572 ein. Dieses Dokument beschreibt eine Vorrichtung zum Testen von so genannten "Multi-Contact Integrated Circuit Chip Packages". Die Vorrichtung umfasst einen mit anisotropisch leitenden Stützkörpern versehenen Chipträger, Kontaktträger mit elektrische Zuführungen, und ein Gehäuse womit eine Vorspannkraft auf den Zuführungen ausgeübt wird.

Die Aufgabe ist erfindungsgemäß gelöst durch ein elektronisches Gerät mit den Merkmalen des Kennzeichnungsteils des Anspruches 1.

Der erfindungsgemäße Stützkörper stellt sicher, dass sich der Bondkontaktträger vorgespannt an der Grundplatte abstützt. Der mindestens eine Bondkontaktträger ist dann über den Stützkörper sicher abgestützt, so dass seine Lage klar definiert ist. Aufgrund der vorgespannten Abstützung ist insbesondere eine Schwingungsneigung des mindestens einen Bondkontaktträgers unterbunden. Es kann daher mit kompakteren Bondkontaktträgern gearbeitet werden. Gegebenenfalls kann auf einen zweiten sogenannten Sicherheitsbond verzichtet werden, wodurch die Ausführung des Bondkontaktträgers nochmals kompakter wird. Wenn mehrere benachbarte Bondkontaktträger vorhanden sind, kann daher das Bondraster enger sein, was zu einem kompakteren Bondbereich des Elektronikgehäuses führt

Ein Überstand nach Anspruch 2 führt zu einer sicheren Vorspannung ohne großen Herstellungsaufwand.

Ein Stützkörper nach Anspruch 3 ermöglicht eine vorgespannte Abstützung auch bei wechselnden Kombinationen von Grundplatten und Elektronikgehäusen, wobei die Dimensionierung des Stützkörpers an das Elektronikgehäuse einerseits und an den Abstand der Bondkontaktträger zur Grundplatte andererseits angepasst wird. Die mechanische Verbindung des Stützkörpers mit dem Elektronikgehäuse kann insbesondere durch ein Verrasten erfolgen.

Ein Stützkörper nach Anspruch 4 lässt sich, was die Ausgestaltung als Ring angeht, einfach zum elektronischen Gehäuse ausrichten. Die Ausgestaltung des Stützkörpers als Mehrzahl von überstehenden Einzelsegmenten erlaubt eine große Flexibilität bei der Gestaltung des Stützkörpers. Eine Anpassung an unterschiedlichste Geometrien der Grundplatte einerseits und des Elektronikgehäuses andererseits ist möglich. Die Einzelsegmente können insbesondere mit dem Elektronikgehäuse verrastet sein, was eine gute Lagedefinition des Stützkörpers gewährleistet.

Eine weitere Aufgabe der Erfindung ist es, ein Verfahren zur sicheren Bereitstellung einer Bondverbindung anzugeben.

Diese Aufgabe ist erfindungsgemäß gelöst durch ein Verfahren mit den im Anspruch 5 angegebenen Merkmalen. Die Vorteile des erfindungsgemäßen Verfahrens entsprechen denen, die oben im Zusammenhang mit dem erfindungsgemäßen elektronischen Gerät ausgeführt wurden.

Ein Ausführungsbeispiel der Erfindung wird nachfolgend anhand der Zeichnung näher erläutert In dieser zeigen:
- Fig.1: eine perspektivische Ansicht eines elektronischen Gerätes; und
- Fig.2: einen Ausschnitt gemäß Linie II-II in Fig. 1.

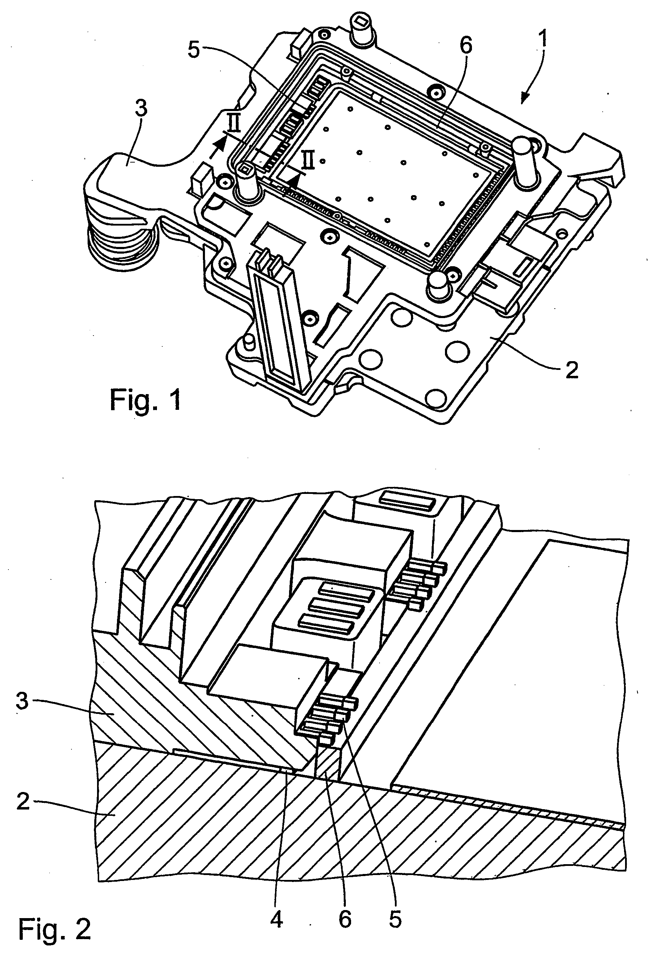

Fig. 1 zeigt in perspektivischer Darstellung ein elektronisches Gerät 1, welches zur Kontaktierung mit einer weiteren elektronischen Komponente, in diesem Fall einem Chip, vorbereitet ist. Das elektronische Gerät 1 umfasst eine Grundplatte 2, die ein Elektronikgehäuse 3 trägt Die Grundplatte 2 ist mit dem Elektronikgehäuse 3 verklebt. Das Elektronikgehäuse 3 liegt auf der Grundplatte 2 unter anderem über eine Auflagerippe 4 an. Letztere ist in der Nachbarschaft einer Mehrzahl von Bondzungen 5 des Elektronikgehäuses 3 angeordnet. Die Bondzungen 5 dienen als Bondkontaktträger zur elektrischen Kontaktierung des Elektronikgehäuses 3 mit der weiteren, in der Zeichnung nicht dargestellten elektronischen Komponente.

Die Bondzungen 5 stützen sich an der Grundplatte 2 über einen Stützkörper 6 ab. Letzterer ist als umlaufender Abstützrahmen in Form eines in etwa rechteckförmig umlaufenden Ringes ausgebildet, der auf der Grundplatte 2 aufliegt. Der Stützkörper 6 ist ein von der Grundplatte 2 separates Bauteil. Die Höhe des Stützkörpers 6 über der Grundplatte 2, also dessen Überstand über die Grundplatte 2, ist größer als der Abstand der Bondzungen 5 zur Grundplatte 2. Dieses Übermaß ist sehr gering und führt dazu, dass der Stützkörper 6 auf die sich hierauf abstützenden Bondzungen 5 eine Vorspannkraft ausübt.

Beim Bonden des elektronischen Gerätes 1 mit Bondkontaktträgern der weiteren elektronischen Komponente wird folgendermaßen vorgegangen: Der Stützkörper 6 wird mit dem Elektronikgehäuse 3 mechanisch verbunden, z. B verrastet. Anschließend wird das Elektronikgehäuse 3 auf die Grundplatte 2 aufgesetzt und mit dieser verklebt. Nach diesem Verbindungsschritt übt der Stützkörper 6 auf die Bondzungen 5 eine Vorspannkraft aus. Anschließend wird eine Bondverbindung zwischen den Bondzungen 5 des Elektronikgehäuses 3 und einem weiteren Bondkontaktträger der mindestens einen weiteren Komponente erzeugt.

Alternativ kann der Stützkörper als Mehrzahl von über die Grundplatte 2 überstehenden Einzelsegmenten, also aus mehreren einzelnen Stützabschnitten, gebildet sein, die mit dem Elektronikgehäuse 3 verrastet bzw. verschnappt sind.

## Patentansprüche

1. Elektronisches Gerät (1)
- mit einer Grundplatte (2),
- mit einem mit der Grundplatte (2) verbundenen Elektronikgehäuse (3) mit mindestens einem Bondkontaktträger (5),
**dadurch gekennzeichnet, dass** sich der Bondkontaktträger (5) an der Grundplatte (2) über einen Stützkörper (6) derart abstützt, dass der Stützkörper (6) auf den Bondkontaktträger (5) eine Vorspannkraft ausübt.

2. Elektronisches Gerät nach Anspruch 1, **dadurch gekennzeichnet, dass** ein Überstand des Stützkörpers (6) über die Grundplatte (2) höher ist als der Abstand des Bondkontaktträgers (5) zur Grundplatte (2).

3. Elektronisches Gerät nach Anspruch 1 oder 2, **dadurch gekennzeichnet, dass** der Stützkörper (6) ein von der Grundplatte (2) separates Bauteil darstellt, das mechanisch mit dem Elektronikgehäuse (3) verbunden ist.

4. Elektronisches Gerät nach einem der Ansprüche 1 bis 3, **dadurch gekennzeichnet, dass** der Stützkörper (6) als überstehender Ring bzw. als Mehrzahl von überstehenden Einzelsegmenten ausgebildet ist.

5. Verfahren zum Bonden eines elektronischen Gerätes (1) mit folgenden Verfahrensschritten:
- Bereitstellen einer Grundplatte (2),
- Verbinden eines Elektronikgehäuses (3) über einen Stützkörper (6) mit der Grundplatte (2) derart, dass der Stützkörper (6) auf den Bondkontaktträger (5) eine Vorspannkraft ausübt,
- Erzeugen einer Bondverbindung zwischen dem Bondkontaktträger (5) des Elektronikgehäuses (3) und einem weiteren Bondkontaktträger.

## Claims

1. An electronic device (1)
- with a base plate (2),
- with a electronic housing (3) connected to the base plate (2) having at least one bond contact pad (5),
**characterised in that** the bond contact pad (5) rests on the base plate (2) by way of a support body (6) such that the support body (6) exerts a pre-tensing force on the bond contact pad (5).

2. The electronic device as claimed in Claim 1, **characterised in that** a projection of the support body (6) over the base plate (2) is higher than the distance of the bond contact pad (5) from the base plate (2).

3. The electronic device as claimed in Claim 1 or 2, **characterised in that** the support body (6) constitutes a component separate from the base plate (2), which is connected mechanically to the electronic housing (3).

4. The electronic device as claimed in any one of Claims 1 to 3, **characterised in that** the support body (6) is designed as a projecting ring or respectively as a plurality of individual projecting segments.

5. A method for bonding an electronic device (1) having the following procedural steps :
- providing a base plate (2),
- connecting an electronic housing (3) by way of a support body (6) to the base plate (2) such that the support body (6) exerts a pre-tensing force on the bond contact pad (5),
- creating a bond connection between the bond contact pad (5) of the electronic housing (3) and a further bond contact pad.

## Revendications

1. Appareil électronique (1)
- avec un socle (2)
- avec un boîtier d'électronique (3) connecté au socle (2) par au moins un porte-contact de liaison (5),
**caractérisé en ce que** le porte-contact de liaison (5) s'appuie sur le socle (2) par un corps d'appui (6) de telle sorte que le corps d'appui (6) exerce une force de précontrainte sur le porte-contact de liaison (5).

2. Appareil électronique selon la revendication 1, **caractérisé en ce qu'**un dépassement du corps d'appui (6) au-dessus du socle (2) est plus élevé que l'écart entre le porte-contact de liaison (5) et le socle (2).

3. Appareil électronique selon la revendication 1 ou 2, **caractérisé en ce que** le corps d'appui (6) représente un élément séparé par rapport au socle (2), lequel élément est relié mécaniquement au boîtier de l'électronique (3).

4. Appareil électronique selon l'une des revendications 1 à 3, **caractérisé en ce que** le corps d'appui (6) est formé comme boucle en saillie ou encore comme multiplicité de segments individuels en saillie.

5. Procédé pour la liaison d'un appareil électronique (1) avec les étapes de procédé suivantes :
- mise à disposition d'un socle (2),
- connexion d'un boîtier d'électronique (3) avec le socle (2) par un corps d'appui (6) de telle sorte que le corps d'appui (6) exerce une force de précontrainte sur le porte-contact de liaison (5),
- production d'une connexion de liaison entre le porte-contact de liaison (5) du boîtier de l'électronique (3) et un autre porte-contact de liaison.
